# EUROPEAN PATENT APPLICATION

(11) **EP 4 509 852 A1**
(43) Date of publication of application: **19.02.2025**
(21) Application number: 23832947.8
(22) Date of filing: 21.06.2023
(51) Int. Cl.: G01R 31/385, G01R 1/073, H01M 10/48

(54) **BATTERY CELL TEST PROBE MECHANISM, TESTING DEVICE AND BATTERY PRODUCTION LINE**

(71) Applicant: Contemporary Amperex Technology (Hong Kong) Limited, Central, Central And Western District (HK)
(72) Inventor: YANG, Jun, Ningde, Fujian 352100 (CN); CAO, Xin, Ningde, Fujian 352100 (CN); CAO, Wei, Ningde, Fujian 352100 (CN)
(74) Representative: Rowlands, Stuart Michael
(86) International application number: PCT/CN2023/101894
(87) International publication number: WO 2024/259671

(57) **Abstract**

This application provides a battery cell testing probe mechanism (100), a testing apparatus (1000), and a battery production line (10000). The battery cell testing probe mechanism (100) includes a connecting member (10) and multiple test members (20). The connecting member (10) is configured to connect to an external structure, and at least one test member (20) is slidably connected to the connecting member (10) along a first direction X. Each test member (20) corresponds to an electrode terminal (4001) of a battery cell (4000) and performs relevant data collection on the corresponding electrode terminal (4001). When battery cells (4000) of different dimensions are tested, one or more test members (20) can be moved relative to the connecting member (10) along the first direction X to adjust spacings between the test members (20), thereby meeting the testing requirements for the spacing between electrode terminals (4001) of battery cells (4000) of different dimensions and improving testing efficiency.

## Description

### TECHNICAL FIELD

This application relates to the field of OCV test technologies, and particularly, to a battery cell testing probe mechanism, a testing apparatus including the battery cell testing probe, and a battery production line including the testing apparatus.

### BACKGROUND

After going through processes such as formation, capacity grading, and labeling, battery cells need to undergo OCV (Open Circuit Voltage, open circuit voltage) test to obtain parameters such as K value (the K value is a voltage drop of the battery cell per unit time, indicating a self-discharge rate of the battery cell), current, voltage, and capacity of the battery cell. This can screen out battery cells with unsatisfactory electrochemical parameters and ensure quality of each batch of battery cells.

Typically, battery cell OCV test is performed on a batch basis. To be specific, battery cells are arranged and the OCV test is performed on battery cells in the same batch at one time. However, when battery cells of different dimensions are tested, especially when the pole spacing of battery cells of different dimensions varies, how to quickly respond and adapt to corresponding testing conditions has become an urgent problem to be solved.

### SUMMARY

The objective of embodiments of this application is to provide a battery cell testing probe mechanism, a testing apparatus, and a battery production line, so as to address a technical issue of low testing efficiency of the testing probe mechanism when testing battery cells of different dimensions.

The technical solution adopted in some embodiments of this application is as follows:

According to a first aspect, some embodiments of this application provide a battery cell testing probe mechanism, configured to test electrode terminals of an incoming battery cell, including:
a connecting member, where the connecting member is configured to connect to an external structure; and
multiple test members, where at least one of the test members is slidably connected to the connecting member along a first direction.

The foregoing technical solution in some embodiments of this application has at least the following technical effects or advantages:

In the battery cell testing probe mechanism provided in an embodiment of this application, each test member corresponds to an electrode terminal of a battery cell and performs relevant data collection on the corresponding electrode terminal. When battery cells of different dimensions are tested, or the spacings between the electrode terminals of the current battery cell are different, one or more test members can be moved relative to the connecting member along the first direction to adjust spacings between the test members, thereby meeting the testing requirements for the spacing between electrode terminals of battery cells of different dimensions and improving testing efficiency.

In some embodiments, at least one of the test members is fitted on the connecting member and is slidable relative to the connecting member.

With the foregoing technical solution, there is sliding friction between the test member and the connecting member, and the relative sliding is achieved via the nested connection. The overall structure is simple and compact in size.

In some embodiments, the battery cell testing probe mechanism further includes a slide rail mechanism, and at least one of the test members is slidably connected to the connecting member via the slide rail mechanism.

With the foregoing technical solution, the test member slides relative to the connecting member via the added slide rail mechanism, resulting in higher sliding stability and less sliding-induced wear of the test member and the connecting member.

In some embodiments, the slide rail mechanism includes a guide rail provided on the connecting member and a sliding block provided on the test member, where the sliding block is slidably connected to the guide rail.

With the foregoing technical solution, the sliding block slides on the guide rail to achieve the sliding of the test members relative to the connecting member.

In some embodiments, the test member includes a test body and a probe provided on the test body, where the test body is slidably connected to the connecting member, one end of the probe abuts against a pole of the battery cell, and the other end of the probe is electrically connected to an external testing device.

With the foregoing technical solution, the probe moves together with the test body under driving of the test body to perform abutting test on a corresponding pole of the battery cell.

In some embodiments, the test body includes a body portion slidably connected to the connecting member and a bearing portion provided on the body portion for supporting the probe, where the bearing portion and the body portion are disposed in a stepped manner along a second direction, the bearing portion has a first end portion, and the body portion has a second end portion, where the first end portion exceeds the second end portion, the probe runs through the first end portion of the bearing portion and extends outside, and the second direction is perpendicular to the first direction.

With the foregoing technical solution, the body portion serves to slidably connect to the connecting member, and the bearing portion serves to support and fix the probe. Along the second direction, the bearing portion and the body portion are disposed in a stepped manner, and the first end portion exceeds the second end portion, allowing the bearing portion and the body portion to enclose an avoidance space between, reducing a risk of the body portion contacting or compressing the battery cell during testing.

In some embodiments, the probe performs soft contact with the electrode terminal of the battery cell.

With the foregoing technical solution, soft contact refers to a contact method that is different from hard contact. Soft contact reduces damage caused by the collision between the probe and the pole, providing protection for both the probe and the pole.

In some embodiments, the probe includes a first tube segment, a second tube segment running through the first tube segment, and an elastic member provided inside the first tube segment, where one end of the elastic member abuts against an inner wall of the first tube segment, and the other end of the elastic member abuts against an end portion of the second tube segment.

With the foregoing technical solution, the second tube segment can move telescopically relative to the first tube segment under elastic expansion and contraction of the elastic member, providing a prerequisite for soft contact.

In some embodiments, the first tube segment has an interference fit with the bearing portion, and the second tube segment has a clearance fit with the bearing portion and can move relative to the bearing portion.

With the foregoing technical solution, the first tube segment is fixedly connected to the bearing portion and remains stationary, while the second tube segment can move relative to the bearing portion, thereby implementing soft contact with the pole of the battery cell.

In some embodiments, the bearing portion includes a first block connected to the body portion and a second block stacked on the first block along the second direction, where the first tube segment has an interference fit with the first block, and the second tube segment has a clearance fit with the second block.

With the foregoing technical solution, the bearing portion is divided into two blocks, facilitating installation of the probe. Specifically, the first tube segment of the probe is first fixed to the first block, and then the second block is stacked on the first block in a way that the second tube segment runs through the second block, so that the second tube segment can move relative to the second block in a telescopic manner.

In some embodiments, the second block has the first end portion, the second block and the first block are disposed in a stepped manner, and the second block is disposed towards a side wall of the body portion and away from the body portion.

With the foregoing technical solution, along the second direction, the second block protrudes outward relative to the body portion, that is, the side wall of the second block, the end surface of the first block, and the surface of the first end portion of the body portion enclose an avoidance space.

In some embodiments, the probe is provided in plurality, and the probes are spaced apart on the test body along a third direction, the third direction being perpendicular to the first direction.

With the foregoing technical solution, placing multiple probes spaced apart along the third direction can increase a contact area with the poles of the battery cells, thereby improving the testing accuracy.

In some embodiments, the battery cell testing probe mechanism includes locking structures, where the locking structure is configured to limit sliding of the test member relative to the connecting member.

With the foregoing technical solution, the locking structure ensures stability of a spatial position of the test member relative to the connecting member, thereby also improving the testing accuracy.

In some embodiments, the locking structure includes a locking screw threaded into the test member, where one end of the locking screw abuts against the connecting member.

With the foregoing technical solution, the locking screw is rotated to apply pressure against the connecting member.

In some embodiments, the locking structure includes a top stud threaded into the test member, where one end of the top stud abuts against the connecting member, and the other end of the stud does not protrude from surface of the connecting member.

With the foregoing technical solution, the stud is rotated to apply pressure against the connecting member, and the stud can be accommodated inside the test member.

In some embodiments, the battery cell testing probe mechanism further includes a limiting structure provided on the connecting member, where the limiting structure is configured to limit a sliding stroke of the test member relative to the connecting member.

With the foregoing technical solution, the limiting structure obstructs the movement of the test member to achieve desired sliding stroke of the test member relative to the connecting member.

In some embodiments, the limiting structure includes a limiting block provided at an end portion of the connecting member.

With the foregoing technical solution, the limiting block obstructs the movement of the test member to achieve maximum sliding stroke of the test member relative to the connecting member.

According to a second aspect, some embodiments of this application further provide a testing apparatus, which includes the foregoing multiple battery cell testing probe mechanisms.

With the foregoing multiple battery cell testing probe mechanisms added, the testing apparatus provided in this embodiment of this application can match poles of battery cells of different dimensions.

According to a third aspect, some embodiments of this application further provide a battery production line including the foregoing testing apparatus.

The battery production line provided in some embodiments of this application, based on having the foregoing testing apparatus, achieves higher production efficiency.

### BRIEF DESCRIPTION OF DRAWINGS

To describe the technical solutions in the embodiments of this application more clearly, the following briefly describes the accompanying drawings required for the embodiments or related technologies. It will be apparent that the accompanying drawings in the following description show merely some embodiments of this application, and a person of ordinary skill in the art may still derive other drawings from these accompanying drawings without creative efforts.
FIG. 1 is a schematic structural diagram of a testing apparatus according to some embodiments of this application;
FIG. 2 is a schematic structural diagram of a battery cell testing probe mechanism according to some embodiments of this application;
FIG. 3 is a left view of a connecting member and a test member of a battery cell testing probe mechanism according to some embodiments of this application;
FIG. 4 is an exploded view of a bearing portion of a battery cell testing probe mechanism according to some embodiments of this application;
FIG. 5 is an exploded view of a probe of a battery cell testing probe mechanism according to some embodiments of this application;
FIG. 6 is a schematic structural diagram of a battery production line according to some embodiments of this application; and
FIG. 7 is a schematic structural diagram of a battery cell according to some embodiments of this application.

Reference signs in the accompanying drawings:
100. battery cell testing probe mechanism;
10. connecting member;
20. test member; 21. test body; 22. probe; 211. body portion; 212. bearing portion; 212a. first end portion; 211a. second end portion; 221. first tube segment; 222. second tube segment; 223. elastic member; 2121. first block; 2122. second block;
30. locking structure; 31. locking screw; 32. stud;
40. limiting structure; 41. limiting block;
50. slide rail mechanism; 51. guide rail; 52. sliding block;
first direction X; second direction Y; third direction Z;
1000. testing apparatus; 200. fixing mechanism;
10000. battery production line; 2000. conveying mechanism; 3000. transfer mechanism; 4000. battery cell; and 4001. electrode terminal.

### DESCRIPTION OF EMBODIMENTS

The embodiments of this application are described in detail below. Examples of the embodiments are shown in the accompanying drawings, and the same or similar reference signs indicate the same or similar components or components with the same or similar functions. The embodiments described below with reference to the drawings are illustrative and are intended to explain this application. They should not be construed as limitations on this application.

Unless otherwise defined, meanings of all technical and scientific terms used in this specification are the same as those commonly understood by persons skilled in the art of this application. The terms used in this specification are merely intended to describe specific embodiments, but not to limit this application. The terms "comprise", "include", and any variants thereof in the descriptions of the specification, claims, and the foregoing accompanying drawings of this application are intended to cover a non-exclusive inclusion.

In the descriptions of this application, the orientations or positional relationships indicated by the terms "length", "width", "thickness", "inside", "outside", "upper", "lower", "left", "right", and the like are based on the orientations or positional relationships as shown in the accompanying drawings. These terms are merely for the ease and brevity of description of this application rather than indicating or implying that the apparatuses or components mentioned must have specific orientations or must be constructed and manipulated according to specific orientations, and therefore shall not be construed as any limitations on this application.

Terms "first" and "second" are merely for the purpose of distinguishing and description and shall not be understood as any indication or implication of relative importance or any implicit indication of the number of the technical features indicated. For example, a first guiding member and a second guiding member are merely used to distinguish different guiding members and do not imply any particular order. The first guiding member can also be named as the second guiding member, and the second guiding member can also be named as the first guiding member, without departing from the scope of the various embodiments described herein. Furthermore, the terms "first", "second", and the like do not limit the features indicated to be different.

In the description of the embodiments of this application, unless otherwise specified and defined explicitly, the terms "connect", "join", and the like should be understood in their general senses. For example, they may refer to a fixed connection, a detachable connection, or an integral connection, may refer to a mechanical connection or an electrical connection, and may refer to a direct connection, an indirect connection via an intermediate medium, an internal communication between two elements, or an interaction between two elements. Persons of ordinary skill in the art can understand specific meanings of these terms in this application as appropriate to specific situations. The term "multiple" means at least two, that is, two or more.

In this application, the term "and/or" is merely for describing an associative relationship of associated objects, indicating that three relationships may be present. For example, A and/or B may indicate three cases: presence of only A; presence of both A and B; and presence of only B. In addition, the character "/" in this specification generally indicates an "or" relationship between contextually associated objects.

It should be noted that, in this application, words such as "in some embodiments", "an example", or "for example" are used to represent an example, an instance, or an illustration. Any embodiment or design solution described as "in some embodiments", "an example", or "for example" in this application shall not be interpreted to be more preferential or advantageous than other embodiments or design solutions. Specifically, the use of terms such as "in some embodiments", "exemplary", and "for example" is intended to present specific concepts in a concrete manner, meaning that specific features, structures, or characteristics described with reference to the embodiments can be included in at least one embodiment of this application. These words appearing in various positions in the specification do not necessarily refer to the same embodiment or an independent or alternative embodiment that is exclusive of other embodiments. It would be explicitly or implicitly understood by persons skilled in the art that the embodiments described herein may be combined with other embodiments.

To achieve the objectives, technical solutions, and advantages of this application more comprehensible, the following describes this application in detail with reference to accompanying drawings and embodiments.

After going through processes such as formation, capacity grading, and labeling, batteries need to undergo OCV (Open Circuit Voltage, open circuit voltage) testing to obtain parameters such as K value (the K value is a voltage drop of the battery cell per unit time, indicating a self-discharge rate of the battery cell), current, voltage, and capacity of the battery. This can screen out batteries with unsatisfactory electrochemical parameters and ensure quality of each batch of batteries.

Typically, batteries are OCV tested using a flow operation, where the batteries are placed in batches on a conveyor line, and several tens or even more batteries can be OCV tested at a time. However, due to differences in size dimensions of the batteries, there are differences in the spacing between the electrode terminals of the battery cells. Therefore, when batteries of different sizes and dimensions are OCV tested, the distance between the testing probes needs to be constantly adjusted for adaptation. For example, in the current batch, the spacing between the electrode terminals of the batteries is A mm, the batteries are placed on a tray with a certain spacing side by side to undergo the OCV test process. However, in the next batch, the spacing between electrode terminals of the batteries is B mm, and the probe spacing for OCV test needs to be adjusted accordingly to meet the OCV test requirements for that batch of batteries. Therefore, the testing efficiency of this process is reduced, especially for batteries with different spacings between the electrode terminals. It is necessary to solve this urgent problem of how to quickly respond and adapt to corresponding testing conditions.

This application provides a battery cell testing probe mechanism for performing OCV test on the electrode terminals of incoming batched battery cells. The battery cell testing probe mechanism includes a connecting member and multiple test members. The connecting member serves the purpose of connecting and bearing, providing a connection for the test members. At least one of the test members is slidable with respect to the connecting member in a first direction, allowing the spacing between the test members to be adjusted to meet the testing requirements of battery cells with different spacing between the electrode terminals. This improves the testing efficiency by quick adaption.

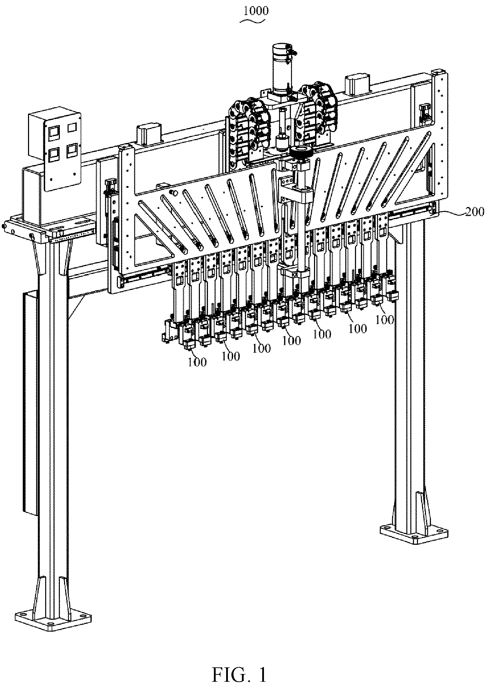

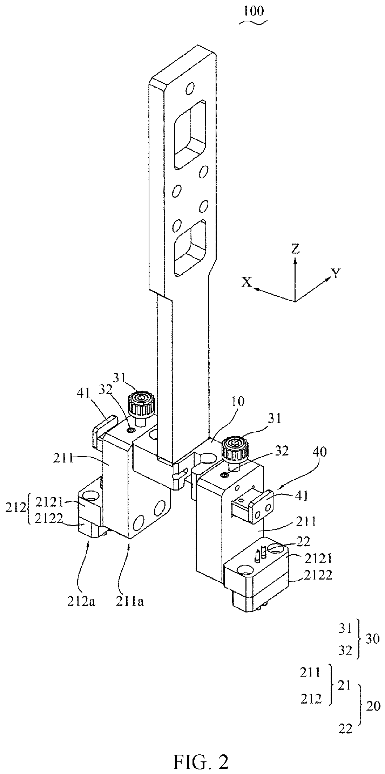

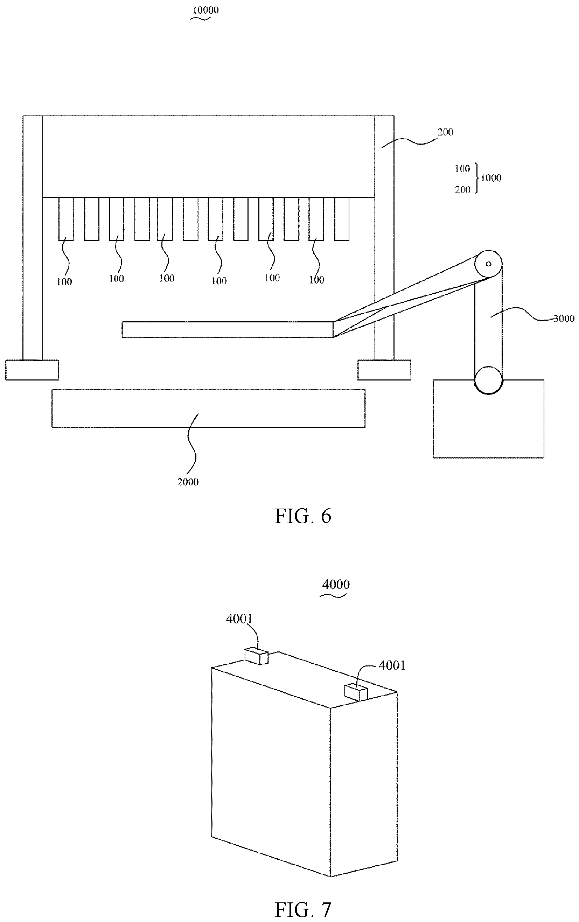

Refer to FIG. 1, FIG. 2, and FIG. 7. FIG. 1 is a schematic structural diagram of a testing apparatus according to an embodiment of this application. FIG. 2 is a schematic structural diagram of a battery cell testing probe mechanism according to an embodiment of this application. FIG. 7 is a schematic structural diagram of a battery cell according to an embodiment of this application.

The testing apparatus 1000 includes multiple battery cell testing probe mechanisms 100 and a fixing mechanism 200. The battery cell testing probe mechanisms 100 are arranged side by side on the fixing mechanism 200 along a preset direction.

The preset direction herein can be referred to as a direction in which battery cells 4000 under test are arranged. Each battery cell testing probe mechanism 100 corresponds to one battery cell 4000 and completes the test by abutting against the electrode terminal 4001.

The battery cell testing probe mechanism 100 is configured to test electrode terminals 4001 of an incoming battery cell 4000 and includes a connecting member 10 and multiple test members 20. At least one test member 20 is slidably connected to the connecting member 10 along a first direction X.

It can be understood that the connecting member 10 serves the purpose of connecting and supporting the test members 20. The connecting member 10 can be provided fixed or connected to an external driving apparatus to obtain corresponding spatial freedom. For example, the connecting member 10 can be a block-shaped or strip-shaped structure. The block-shaped or strip-shaped structure can be connected to an external driving apparatus. The driving apparatus includes but is not limited to a telescopic cylinder, a screw mechanism, a lifting mechanism, a rotating mechanism, and the like. In this way, the block-shaped or strip-shaped structure can obtain spatial freedom of movement or rotation.

The test members 20 are configured to abut against the electrode terminals 4001 of the battery cells 4000 and collect electrical signals. The test members 20 is electrically connected to an external electrical testing apparatus to transmit the collected electrical signals to the external electrical testing apparatus. Specifically, during testing, each test member 20 sequentially abuts against each electrode terminal 4001 of the battery cells 4000. Herein, two electrode terminals 4001 are used as an example, the positive and negative electrode poles of the battery cell 4000 are spaced apart. There are two test members 20, and at least one test member 20 is slidable relative to the connecting member 10 along the first direction X, so as to match the change in the spacing between the positive and negative electrode poles of the battery cells 4000 in different batches. Certainly, the battery cell 4000 can be provided with more than two electrode terminals 4001, and in this case, the number of test members 20 can increase accordingly with increase of the number of electrode terminals 4001.

Herein, the first direction X is a direction in which the electrode terminals 4001 of the battery cell 4000 are spaced apart. Since the spacings between the electrode terminals 4001 of the battery cells 4000 of different sizes and dimensions are different, one test member 20 can be selected to slide relative to the connecting member 10 along the first direction X, or multiple test members 20 can be selected to slide relative to the connecting member 10 along the first direction X, so as to match the change in spacing between the electrode terminals 4001 of the battery cells 4000.

Herein, the sliding of the test member 20 along the first direction X relative to the connecting member 10 refers to sliding in either positive or negative direction of the first direction X.

A sliding form between each test member 20 and the connecting member 10 can be direct sliding, indirect sliding, or a combination of partial direct sliding and partial indirect sliding.

For example, a guide structure such as a groove or a slide rail is provided on the connecting member 10, and the test member 20 is provided with a sliding structure that matches the guide structure. The sliding structure can include, but is not limited to, a protrusion or a rib. Matching the sliding structure with the guide structure allows each test member 20 to slide on the connecting member 10.

Alternatively, the test members 20 can be slidably connected to the connecting member 10 via a sliding mechanism. The sliding mechanism includes a guide rail and a sliding block that matches the guide rail. The guide rail is disposed on the connecting member 10 along the first direction X, and the test members 20 are connected to the guide rail via the sliding block, so as to meet the requirement of sliding relative to the connecting member 10.

In the battery cell testing probe mechanism 100 provided in an embodiment of this application, each test member 20 corresponds to an electrode terminal 4001 of a battery cell 4000 and performs relevant data collection on the corresponding electrode terminal 4001. When processing battery cells 4000 of different dimensions, or the spacings between the electrode terminals 4001 of the current battery cell 4000 are different, one or more test members 20 can be moved relative to the connecting member 10 along the first direction X to adjust spacings between the test members 20, thereby meeting the testing requirements for the spacing between electrode terminals 4001 of battery cells 4000 of different dimensions and improving testing efficiency.

Refer to FIG. 2. In some embodiments, at least one test member 20 is fitted on the connecting member 10 and slides relative to the connecting member 10.

It can be understood that in this embodiment, at least one test member 20 is directly slidably connected to the connecting member 10. Specifically, a through hole is provided on the current test member 20, and a shape of the through hole matches an outer shape of the connecting member 10. The connecting member 10 can run through the through hole to slidably connect to the test member 20.

For example, the connecting member 10 is a strip-shaped structure, and the test member 20 has a square-shaped through hole that matches the strip-shaped connecting member 10.

With this arrangement, there is sliding friction between the test member 20 and the connecting member 10, and the relative sliding is achieved via the nested connection. The overall structure is simple and compact in size.

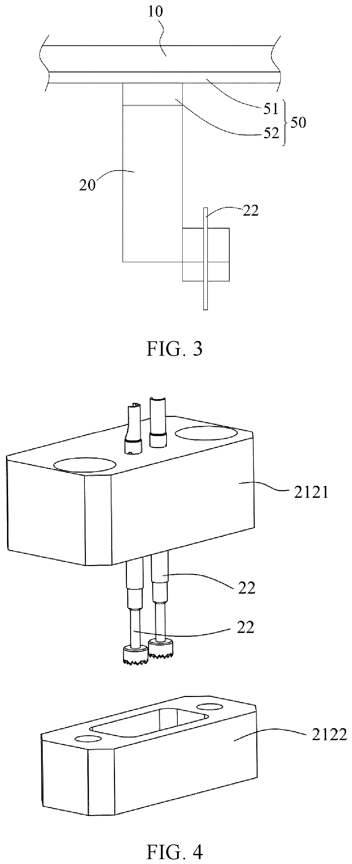

Refer to FIG. 3. In some embodiments, the battery cell testing probe mechanism 100 further includes a slide rail mechanism 50, at least one test member 20 is slidably connected to the connecting member 10 via the slide rail mechanism 50.

It can be understood that in this embodiment, at least one test member 20 is indirectly slidably connected to the connecting member 10. That is, a slide rail mechanism 50 is added to achieve the slidable connection. The slide rail mechanism 50 should include two portions: a guiding portion and a sliding portion. Depending on actual usage requirements, the guiding portion is disposed on one of the test member 20 and the connecting member 10, and the sliding portion is disposed on the other one of the test member 20 and the connecting member 10. The sliding portion slides on the guiding part to achieve a desired connection.

With this arrangement, the test member 20 slides relative to the connecting member 10 via the added slide rail mechanism 50, resulting in higher sliding stability and less sliding-induced wear of the test member 20 and the connecting member 10.

Refer to FIG. 2. In some embodiments, the slide rail mechanism 50 includes a guide rail 51 provided on the connecting member 10 and a sliding block 52 provided on the test member 20. The sliding block 52 is slidably connected to the guide rail 51.

Specifically, the guide rail 51 is arranged on the connecting member 10 along the first direction X, and at least one sliding block 52 is provided on the test member 20. The sliding block 52 is slidably connected to the guide rail 51.

With this arrangement, the matched sliding block 52 in the slide rail mechanism 50 slides on the guide rail 51, allowing the test member 20 to slide relative to the connecting member along the first direction X.

Refer to FIG. 2. In some embodiments, the test member 20 includes a test body 21 and a probe 22 provided on the test body 21. The test body 21 is slidably connected to the connecting member 10, where one end of the probe 22 abuts against the pole of the battery cell 4000, and the other end is electrically connected to an external testing device.

It can be understood that the test body 21 serves to support the probe 22, and the probe 22 moves with the test body 21 to match the testing requirements of battery cells 4000 with different distances between electrode terminals 4001.

Herein, a shape and a structure of the test body 21 include, but are not limited to, a rectangular structure, an L-shaped structure, and the like.

With this arrangement, the probe 22 moves with the test body 21 under driving of the test body 21 to perform abutting test on a corresponding pole of the battery cell 4000.

Refer to FIG. 2. In some embodiments, the test body 21 includes a body portion 211 slidably connected to the connecting member 10 and a bearing portion 212 on the body portion 211 for bearing the probe 22. Along the second direction Z, the bearing portion 212 and the body portion 211 are disposed in a stepped manner. The bearing portion 212 is provided with a first end portion 212a, and the body portion 211 is provided with a second end portion 211a. The first end portion 212a exceeds a second end portion 211a, the probe 22 runs through the first end portion 212a of the bearing portion 212 and extends outside, and the second direction Z is perpendicular to the first direction X.

Herein, the slidable connection between the body portion 211 and the connecting member 10 can be a direct slidable connection, an indirect slidable connection, or a combination of the two slidable connection manners. The body portion 211 mainly serves to support and connect the bearing portion.

The bearing portion 212 mainly serves to support the probe 22 and drive the probe 22 to move along the first direction X.

For example, both the body portion 211 and the bearing portion 212 can possess a block-like structure, thereby facilitating processing and connection.

The second direction Z is a direction perpendicular to the first direction X. When the electrode terminals 4001 are located on an end surface corresponding to the thickness and length of the battery cell 4000, the first direction X can be a thickness or length direction of the incoming battery cell 4000, and the second direction Z is a width direction of the battery cell 4000. Alternatively, when the electrode terminals 4001 are located on an end surface corresponding to the width and length of the battery cell 4000, the first direction X can be the width or length direction of the incoming battery cell 4000, and the second direction Z is the thickness direction of the battery cell 4000. Alternatively, when the electrode terminals 4001 are located on an end surface corresponding to the thickness and width of the battery cell 4000, the first direction X can be the thickness or width direction of the incoming battery cell 4000, and the second direction Z is the length direction of the battery cell 4000.

The first end portion 212a of the bearing portion 212 is an end portion away from the body portion 211, and the second end portion 211a of the body portion 211 faces to the same direction of the first end portion 212a. Along the second direction Z, the first end portion 212a of the bearing portion 212 exceeds the second portion of the body portion 211, resulting in a stepped arrangement of the bearing portion 212 and the body portion 211. The probe 22 runs through the first end portion 212a of the bearing portion 212 and extends outside. Optionally, the probe 22 runs through the bearing portion 212 along the second direction Z and extends from the first end portion 212a to the outside.

With this arrangement, the body portion 211 serves to slidably connect to the connecting member 10, and the bearing portion 212 serves to support and fix the probe 22. Along the second direction Z, the bearing portion 212 and the body portion 211 are disposed in a stepped manner, and the first end portion 212a exceeds the second end portion 211a, allowing the bearing portion 212 and the body portion 211 to enclose an avoidance space between, reducing a risk of the body portion 211 contacting or compressing the battery cell 4000 during testing.

In some embodiments, the probe 22 is in soft contact with the electrode terminal 4001 of the battery cell 4000.

It can be understood that soft contact refers to a contact method that is different from hard contact. Soft contact reduces damage caused by the collision between the probe 22 and the pole, providing protection for both the probe 22 and the pole.

For example, the probe 22 has elasticity, and when directly contacting the electrode terminal 4001 of the battery cell 4000, the probe 22 undergoes compression along the second direction Z, thereby providing a cushioning effect.

For example, a buffer member is provided on the end portion of the incoming battery cell 4000 away from the electrode terminal 4001, allowing the battery cell 4000 to have freedom of movement in the second direction Z. In this way, when the probe 22 abuts against the electrode terminal 4001 of the battery cell 4000, the buffer member acts as a buffer and releases force. The buffer member can include, but is not limited to, a silicone pad, foam block, rubber layer, and the like.

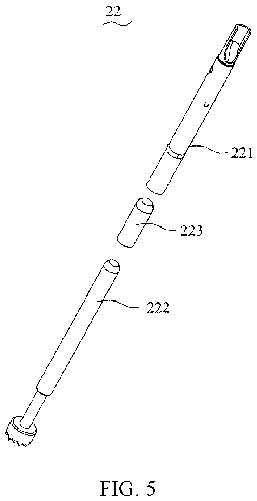

Refer to FIG. 5. In a specific embodiment, the probe 22 includes a first tube segment 221, a second tube segment 222 running through the first tube segment 221, and an elastic member 223 provided inside the first tube segment 221. One end of the elastic member 223 abuts against an inner wall of the first tube segment 221, and the other end abuts against the end portion of the second tube segment 222.

Herein, the first tube segment 221 is used for electrical connection with an external testing device, and the second tube segment 222 is used for abutting against the electrode terminal 4001 of the battery cell. The elastic member 223 allows the second tube segment 222 to move telescopically along an axial direction of the second tube segment 222 relative to the first tube segment 221. The elastic member 223 can include, but is not limited to, a spring, silicone pad, foam block, rubber layer, and the like.

With this arrangement, the second tube segment 222 can move telescopically relative to the first tube segment 221 under elastic expansion and contraction of the elastic member 223, providing a prerequisite for soft contact.

Optionally, a protrusion can be provided on the inner wall of the first tube segment 221. One end of the elastic member 223 abuts against the protrusion, and the other end abuts against the end portion of the second tube segment 222.

In some embodiments, the first tube segment 221 has an interference fit with the bearing portion 212, and the second tube segment 222 has a clearance fit with the bearing portion 212 and can move relative to the bearing portion 212.

Herein, the first tube segment 221 is inserted into the bearing portion 212 by compression or insertion. Specifically, the bearing portion 212 is provided with a corresponding first hole structure, where the first hole structure has an interference fit with the first tube segment 221. The second tube segment 222 can move telescopically relative to the bearing portion 212. Specifically, the bearing portion 212 is provided with a corresponding second hole structure, where the second hole structure has a clearance fit with the second tube segment 222, and this clearance fit allows smooth relative movement between the two.

With this arrangement, the first tube segment is fixedly connected to the bearing portion 212 and remains stationary, while the second tube segment 222 can move relative to the bearing portion 212, thereby implementing soft contact with the pole of the battery cell 4000.

Refer to FIG. 4. In some embodiments, the bearing portion 212 includes a first block 2121 connected to the body portion 211 and a second block 2122 stacked along the second direction Z on the first block 2121. The first tube segment 221 has an interference fit with the first block 2121, and the second tube segment 222 has a clearance fit with the second block 2122.

It can be understood that the first tube segment 221 is inserted into the first block 2121 by compression or insertion. Specifically, the first block 2121 is provided with a corresponding first hole structure, where the first hole structure has an interference fit with the first tube segment 221. The second tube segment 222 can move telescopically relative to the second block 2122. Specifically, the second block 2122 is provided with a corresponding second hole structure, where the second hole structure has a clearance fit with the second tube segment 222, and this clearance fit allows smooth relative movement between the two.

With this arrangement, the bearing portion 212 is divided into two blocks, facilitating the installation of the probe 22. Specifically, the first tube segment 221 of the probe 22 is first fixed to the first block 2121, and then the second block 2122 is stacked on the first block 2121 in a way that the second tube segment 222 runs through the second block 2122, so that the second tube segment 222 can move relative to the second block 2122 in a telescopic manner.

Refer to FIG. 2. In some embodiments, the second block 2122 has a first end portion 212a, and the second block 2122 and the first block 2121 are disposed in a stepped manner. The second block 2122 faces a side wall of the body portion 211 and is disposed away from the body portion 211.

It can be understood that, along the second direction Z, the second block 2122 protrudes outward relative to the body portion 211. The side wall of the second block 2122, the end surface of the first block 2121, and the surface of the first end portion 212a of the body portion 211 enclose an avoidance space. The avoidance space can accommodate protruding structures on the battery cell 4000 and also prevent the second end portion 211a of the body portion 211 from contacting the electrode terminal 4001 of the battery cell 4000.

Refer to FIG. 2. In some embodiments, there are multiple probes 22, and each probe 22 is spaced apart on the test body 21 along the third direction Y. The third direction Y is perpendicular to the first direction X.

It can be understood that the third direction Y represents an arrangement direction of the probes 22, and the third direction Y is also related to the arrangement of the incoming battery cells 4000. For example, when the electrode terminals 4001 of the incoming battery cells 4000 are located on the end surface corresponding to the thickness and length of the battery cells 4000, the third direction Y can be the thickness or length direction of the incoming battery cells 4000. Alternatively, when the electrode terminals 4001 of the incoming battery cells 4000 are located on the end surface corresponding to the width and length of the battery cells 4000, the third direction Y can be the width or length direction of the incoming battery cells 4000. Alternatively, when the electrode terminals 4001 of the incoming battery cells 4000 are located on the end surface corresponding to the thickness and width of the battery cells 4000, the third direction Y can be the thickness or width direction of the incoming battery cells 4000.

Additionally, increasing the number of probes 22 allows for accommodating different width requirements of the electrode terminals 4001 in the third direction Y. This, in turn, improves accuracy of collection performed by the test member 20 on the corresponding electrode terminal 4001 of the battery cell 4000.

Optionally, there are two probes 22, and the two probes 22 are alternately spaced along the third direction Y. A distance between the two probes 22 is smaller than the width of the electrode terminal 4001 of the battery cell 4000 in the third direction Y. With this arrangement, when abutting against the electrode terminals 4001 of the battery cells 4000, both probes 22 can complete the abutting action.

With this arrangement, placing multiple probes 22 spaced apart along the third direction Y can increase a contact area with the poles of the battery cells 4000, thereby improving the testing accuracy.

Refer to FIG. 2. In some embodiments, the battery cell testing probe mechanism 100 includes locking structures 30, where the locking structure 30 is configured to limit sliding of the test member 20 relative to the connecting member 10.

It can be understood that the locking structure 30 is used for locking the test member 20 to reduce probability of relative sliding between the test member 20 and the connecting member 10.

With this arrangement, the locking structure 30 ensures stability of a spatial position of the test member 20 relative to the connecting member 10, thereby also improving the testing accuracy.

Optionally, the locking piece runs through the test member 20 and remains stationary relative to the connecting member 10 by means of abutting.

Refer to FIG. 2. In some embodiments, the locking structure 30 includes a locking screw 31 threaded into the test member 20, and one end of the locking screw 31 abuts against the connecting member 10.

It can be understood that a threaded hole is provided in the test member 20, and the locking screw 31 is screwed into the threaded hole until it abuts against the connecting member 10, thereby preventing relative sliding between the test member 20 and the connecting member 10.

With this arrangement, the locking screw 31 is rotated to apply pressure against the connecting member 10.

Refer to FIG. 2. In some embodiments, the locking structure 30 includes a stud 32 threaded into the test member 20, where one end of the stud 32 abuts against the connecting member 10, and the other end of the stud 32 does not protrude beyond surface of the connecting member 10.

Similarly, a threaded hole is provided in the test member 20, and the stud 32 is screwed into the threaded hole until it abuts against the connecting member 10, thereby preventing relative sliding between the test member 20 and the connecting member 10. Unlike the locking screw 31, the stud 32 can be fully screwed into the test member 20, that is, hidden inside the test member 20 in appearance.

With this arrangement, the stud 32 is rotated to apply pressure against the connecting member 10, and the stud 32 can be accommodated inside the test member 20, resulting in a simple appearance.

Refer to FIG. 2. In some embodiments, the battery cell testing probe mechanism 100 further includes a limiting structure 40 provided on the connecting member 10, and the limiting structure 40 is configured to limit a sliding stroke of the test member 20 relative to the connecting member 10.

It can be understood that the limiting structure 40 includes but is not limited to a protrusion, a block, or a plate, which can obstruct movement of the test member 20 along its sliding path relative to the connecting member 10. Typically, the limiting structure 40 is disposed on the connecting member 10 to define the maximum sliding stroke of the test member 20.

With this arrangement, the limiting structure 40 obstructs the movement of the test member 20 to achieve desired sliding stroke of the test member 20 relative to the connecting member 10.

Refer to FIG. 2. In a specific embodiment, the limiting structure 40 includes a limiting block 41 located at the end portion of the connecting member 10.

With this arrangement, the limiting block 41 obstructs the movement of the test member 20 to achieve maximum sliding stroke of the test member 20 relative to the connecting member 10.

Refer to FIG. 1. In some embodiments, this application further provides a testing apparatus 1000, which includes the foregoing multiple battery cell testing probe mechanisms 100.

With the foregoing multiple battery cell testing probe mechanisms 100 added, the testing apparatus 1000 provided in this embodiment of this application can match poles of battery cells 4000 of different dimensions.

Refer to FIG. 1. The testing apparatus 1000 further includes a fixing mechanism 200, where the multiple battery cell testing probe mechanisms 100 are spaced apart on the fixing mechanism 200.

It can be understood that the fixing mechanism 200 serves to connect and support the multiple battery cell testing probe mechanisms 100. The fixing mechanism 200 can be provided fixed or connected to an external driving apparatus to obtain corresponding spatial freedom. For example, the fixing mechanism 200 can be a gantry structure mounted on the OCV test station of the incoming production line. Alternatively, the fixing mechanism 200 can be a plate-shaped or block-shaped structure. The plate-shaped or block-shaped structure can be connected to an external driving apparatus. The driving apparatus includes but is not limited to a telescopic cylinder, a screw mechanism, a lifting mechanism, a rotating mechanism, and the like. In this way, the plate-shaped or block-shaped structure can obtain spatial freedom of movement or rotation.

Refer to FIG. 6 and FIG. 7. In some embodiments, this application further provides a battery production line 10000, including the foregoing testing apparatus 1000.

With the foregoing testing apparatus 1000 added, the battery production line 10000 provided in this embodiment of this application achieves higher production efficiency.

It can be understood that the battery production line 10000 further includes a conveying mechanism 2000, where the conveying mechanism 2000 is configured to transport the battery cells 4000 under test to a testing station. Additionally, the battery production line 10000 includes a transfer mechanism 3000, where the transfer mechanism 3000 is configured to remove battery cells 4000 of a same batch from the conveying mechanism 2000 and transfer them to the testing apparatus 1000.

The foregoing are merely preferable embodiments of this application, but are not intended to limit this application. Any modification, equivalent replacement, or improvement made without departing from the spirit and principle of this application shall fall within the protection scope of this application.

## Claims

1. A battery cell testing probe mechanism configured to test electrode terminals of an incoming battery cell, **characterized by** comprising:
a connecting member, wherein the connecting member is configured to connect to an external structure; and
multiple test members, wherein at least one of the test members is slidably connected to the connecting member along a first direction.

2. The battery cell testing probe mechanism according to claim 1, **characterized in that** at least one of the test members is fitted on the connecting member and is slidable relative to the connecting member.

3. The battery cell testing probe mechanism according to claim 1, **characterized in that** the battery cell testing probe mechanism further comprises a slide rail mechanism, wherein at least one of the test members is slidably connected to the connecting member via the slide rail mechanism.

4. The battery cell testing probe mechanism according to claim 3, **characterized in that** the slide rail mechanism comprises a guide rail provided on the connecting member and a sliding block provided on the test member, wherein the sliding block is slidably connected to the guide rail.

5. The battery cell testing probe mechanism according to any one of claims 1 to 4, **characterized in that** the test member comprises a test body and a probe provided on the test body, wherein the test body is slidably connected to the connecting member, one end of the probe abuts against a pole of the battery cell, and the other end of the probe is electrically connected to an external testing device.

6. The battery cell testing probe mechanism according to claim 5, **characterized in that** the test body comprises a body portion slidably connected to the connecting member and a bearing portion provided on the body portion for supporting the probe, wherein the bearing portion and the body portion are disposed in a stepped manner along a second direction, the bearing portion has a first end portion, and the body portion has a second end portion, wherein the first end portion exceeds the second end portion, the probe runs through the first end portion of the bearing portion and extends outside, and the second direction is perpendicular to the first direction.

7. The battery cell testing probe mechanism according to claim 5 or 6, **characterized in that** the probe is in soft contact with the pole of the battery cell.

8. The battery cell testing probe mechanism according to claim 7, **characterized in that** the probe comprises a first tube segment, a second tube segment running through the first tube segment, and an elastic member provided inside the first tube segment, wherein one end of the elastic member abuts against an inner wall of the first tube segment, and the other end of the elastic member abuts against an end portion of the second tube segment.

9. The battery cell testing probe mechanism according to claim 8, **characterized in that** the first tube segment has an interference fit with the bearing portion, and the second tube segment has a clearance fit with the bearing portion and is movable relative to the bearing portion.

10. The battery cell testing probe mechanism according to claim 9, **characterized in that** the bearing portion comprises a first block connected to the body portion and a second block stacked on the first block along the second direction, wherein the first tube segment has an interference fit with the first block, and the second tube segment has a clearance fit with the second block.

11. The battery cell testing probe mechanism according to claim 10, **characterized in that** the second block has the first end portion, the second block and the first block are disposed in a stepped manner, and the second block is disposed towards a side wall of the body portion and away from the body portion.

12. The battery cell testing probe mechanism according to any one of claims 5 to 11, **characterized in that** the probe is provided in plurality, and the probes are spaced apart on the test body along a third direction, the third direction being perpendicular to the first direction.

13. The battery cell testing probe mechanism according to any one of claims 1 to 12, **characterized in that** the battery cell testing probe mechanism comprises locking structures, wherein the locking structure is configured to limit sliding of the test member relative to the connecting member.

14. The battery cell testing probe mechanism according to claim 13, **characterized in that** the locking structure comprises a locking screw threaded into the test member, wherein one end of the locking screw abuts against the connecting member.

15. The battery cell testing probe mechanism according to claim 13 or 14, **characterized in that** the locking structure comprises a stud threaded into the test member, wherein one end of the stud abuts against the connecting member, and the other end of the stud does not protrude from surface of the connecting member.

16. The battery cell testing probe mechanism according to any one of claims 1 to 15, **characterized in that** the battery cell testing probe mechanism further comprises a limiting structure provided on the connecting member, wherein the limiting structure is configured to limit a sliding stroke of the test member relative to the connecting member.

17. The battery cell testing probe mechanism according to claim 16, **characterized in that** the limiting structure comprises a limiting block provided at an end portion of the connecting member.

18. A testing apparatus **characterized by** comprising multiple battery cell testing probe mechanisms according to any one of claims 1 to 17.

19. A battery production line **characterized by** comprising the testing apparatus according to claim 18.
